# EUROPEAN PATENT APPLICATION

(11) **EP 4 764 697 A1**
(43) Date of publication of application: **24.06.2026**
(21) Application number: 24221544.0
(22) Date of filing: 19.12.2024
(51) Int. Cl.: G03F 1/62, G03F 1/82, G03F 7/20

(54) **SYSTEM AND METHOD FOR DETECTING A BREAK IN A PELLICLE**

(71) Applicant: ASML Netherlands B.V., 5500 AH Veldhoven (NL)
(72) Inventor: BROUNS, Derk, Servatius, Gertruda, 5500 AH Veldhoven (NL); MARVI, Zahra, 5500 AH Veldhoven (NL)
(74) Representative: ASML Netherlands B.V.

(57) **Abstract**

The present invention provides a system for detecting a break in a pellicle for use with a patterning device in a lithographic apparatus, the system comprising: a support structure for holding a patterning device, the support structure being electrically coupled to the patterning device; a sensor configured to measure, via the electrical coupling, a property associated with potential induced on the patterning device due to photons reaching the patterning device during exposure, wherein the system is configured to detect the break in the pellicle based on the measured property.

## Description

### FIELD

The present description relates to a system and method for detecting a break in a pellicle and a method of attaching a sensor to a support structure. A pellicle may be suitable for use with a patterning device for a lithographic apparatus. The present description has particular, but not exclusive, pertinence to an EUV lithographic apparatus and/or an EUV tool.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus that uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

The use of pellicles in lithography is well-known and well-established. A typical pellicle in a DUV lithographic apparatus is a membrane which is located away from the patterning device and is out of the focal plane of a lithographic apparatus in use. Because the pellicle is out of the focal plane of the lithographic apparatus, contamination particles which land on the pellicle are out of focus in the lithographic apparatus. Consequently, images of the contamination particles are not projected onto the substrate. If the pellicle were not present, then a contamination particle which landed on the patterning device would be projected onto the substrate and would introduce a defect into the projected pattern.

It may be desirable to use a pellicle in an EUV lithographic apparatus. EUV lithography differs from DUV lithography in that it is typically performed in a vacuum and the patterning device is typically reflective rather than being transmissive.

### SUMMARY

It is desirable to provide an apparatus and method for determining a break in a pellicle which overcomes or mitigates one or more problems associated with the art. Examples described herein may have use in an EUV lithographic apparatus. Examples described herein may also have use in a DUV lithographic apparatus and/or another form of lithographic tools. Examples described herein may also have use in other tools that use EUV or DUV and/or that are associated with a lithographic process (e.g., an inspection tool such as a patterning device inspection tool).

According to an aspect, there is provided a system for detecting a break in a pellicle for use with a patterning device in a lithographic apparatus, the system comprising: a support structure for holding a patterning device, the support structure being electrically coupled to the patterning device; a sensor configured to measure, via the electrical coupling, a property associated with potential induced on the patterning device due to photons reaching the patterning device during exposure, wherein the system is configured to detect the break in the pellicle based on the measured property.

According to an aspect, there is provided a lithographic apparatus comprising: an illumination system configured to condition a radiation beam; the system described herein, wherein the patterning device is capable of imparting the radiation beam with a pattern to form a patterned radiation beam; a substrate table configured to hold a substrate; and a projection system configured to project the patterned radiation beam onto the substrate.

According to an aspect, there is provided a method of detecting a break in a pellicle for use with a patterning device in a lithographic apparatus, wherein the patterning device is held by a support structure which is electrically coupled to the patterning device, the method comprising measuring, via the electrical coupling, a property associated with potential induced on the patterning device due to photons reaching the patterning device during exposure and detecting the break in the pellicle based on the measured property.

According to an aspect, there is provided a method of providing the system described herein, wherein the method comprises attaching the sensor to the support structure, wherein the support structure comprises a pre-existing electrical coupling between the support structure and the patterning device.

### BRIEF DESCRIPTION OF THE DRAWINGS

Embodiments of the invention will now be described, by way of example only, with reference to the accompanying schematic drawings, in which:
Figure 1 schematically depicts a lithographic system comprising a lithographic apparatus including an example pellicle assembly;
Figure 2 schematically depicts a side view of a pellicle assembly and a patterning device;
Figure 3 schematically depicts a system according to an embodiment;
Figure 4 schematically depicts a circuit representing at least part of the system of Figure 3; and
Figure 5 depicts a graph showing variation in a signal measured by the system.

### DETAILED DESCRIPTION

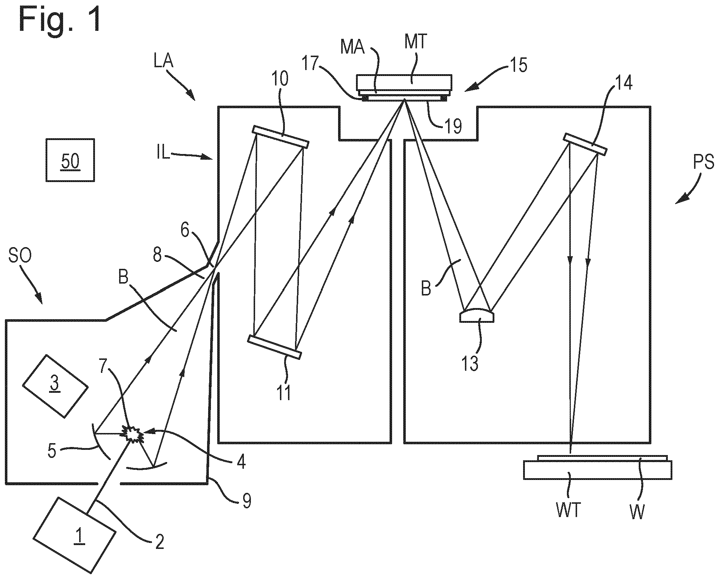

Figure 1 shows a lithographic system according to an embodiment of the invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the patterning device MA) onto the substrate W. The substrate W may include previously formed patterns. Where this is the case, the lithographic apparatus LA aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser 1, which may for example be a CO2 laser, is arranged to deposit energy via a laser beam 2 into a fuel, such as tin (Sn) which is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure that is arranged to reflect EUV radiation (e.g. EUV radiation having a desired wavelength such as about 13.5 nm). The collector 5 may have an ellipsoidal configuration, having two ellipse focal points. A first focal point may be at the plasma formation region 4, and a second focal point may be at an intermediate focus 6, as discussed below.

The laser 1 may be remote from the radiation source SO. Where this is the case, the laser beam 2 may be passed from the laser 1 to the radiation source SO with the aid of a beam delivery system (not shown) comprising, for example, suitable directing mirrors and/or a beam expander, and/or other optics. The laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular intensity distribution. The radiation beam B passes from the illumination system IL and is incident upon the patterning device MA held by the support structure MT. The support structure MT may be, or may comprise a clamp, and particularly an electrostatic clamp.

The patterning device MA is protected by a pellicle 19, which is held in place by a pellicle frame 17. The pellicle 19 and the pellicle frame 17 together form a pellicle assembly 15. The patterning device MA (which may for example be a mask) reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system PS comprises a plurality of mirrors which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation source SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

The lithographic apparatus may comprise controller 50. The controller 50 may be electronically connected the components of the lithographic apparatus LA described herein. The controller 50 may be a processor (such as a computer) configured to control the lithographic apparatus LA. The controller 50 may also include processing circuitry configured to execute data, signal and image processing functions for example on a data set e.g. embodied as signals such as detection signals. The controller 50 may thus include processing circuitry configured to execute processing functions on signal, image and other data produced. While the controller 50 is shown in Figure 1 as being outside of the various systems (e.g. the illumination system IL and the projection system PS), it is appreciated that the controller 50 may be part of at least one of these systems. The controller 50 may be located in one of the systems or it may be distributed over at least two of the systems. The controller 50 may comprise hardware and/or software.

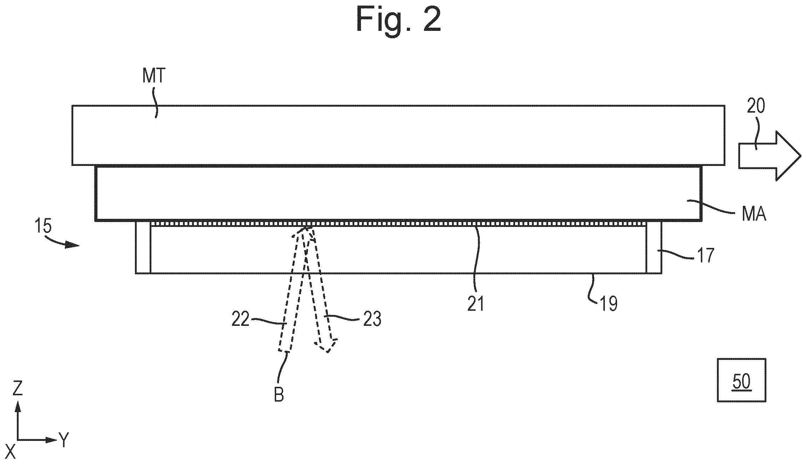

As was described briefly above, the pellicle assembly 15 includes the pellicle 19 that is provided adjacent to the patterning device MA. The pellicle 19 is provided in the path of the radiation beam B such that radiation beam B passes through the pellicle 19 both as it approaches the patterning device MA from the illumination system IL and as it is reflected by the patterning device MA towards the projection system PS, as shown in Figure 2. This position of the pellicle 19 in the lithographic apparatus LA is an EUV radiation exposure position. The pellicle 19 comprises a thin film that is substantially transparent to EUV radiation (although it will absorb a small amount of EUV radiation). By EUV transparent pellicle or a film substantially transparent for EUV radiation herein is meant that the pellicle 19 is transmissive for at least 65% of the EUV radiation, at least 80% of the EUV radiation or at least 90% of the EUV radiation. The pellicle 19 acts to protect the patterning device MA from particle contamination. The pellicle 19 may be herein referred to as an EUV transparent pellicle. The pellicle 19 may be made from any material which is sufficiently transparent for EUV radiation, such as metal silicide MexSiy (including the stable stoichiometric variants and its nitrides). Examples are MoSi₂, YSi₂, ZrSi₂, LaSi₂, NbSi₂, RuSi₂ and TiSi₂, or any other stable stoichiometry thereof, such as RuSi, LaSi, Mo₃Si, Mo₅Si₃, ZrSi, Zr₂Si, TiSi and Nb₅Si₃. A nitrided metal silicide has the formula Meₓ(Si)_{y}N_{z}, wherein x ≤ y ≤ 2x, and 0 < z ≤ x. The metal may be selected from: Ce, Pr, Sc, Eu, Nd, Ti, V, Cr, Zr, Nb, Mo, Ru, Rh, La, Y, or Be. Preferably the metal is molybdenum.. The metal silicide may be stronger than silicon at high temperatures because it cools more quickly than silicon. In other examples, the pellicle may be made from other materials, such as silicon, silicon nitride, graphene or graphene derivatives, carbon nanotube (CNT), or multilayer membranes formed by alternating EUV transparent materials.

While efforts may be made to maintain a clean environment inside the lithographic apparatus LA, particles may still be present inside the lithographic apparatus LA. In the absence of the pellicle 19, particles may be deposited onto the patterning device MA. Particles on the patterning device MA may disadvantageously affect the pattern that is imparted to the radiation beam B and therefore the pattern that is transferred to the substrate W. The pellicle 19 provides a barrier between the patterning device MA and the environment in the lithographic apparatus LA in order to prevent particles from being deposited on the patterning device MA.

In use, the pellicle 19 is positioned at a distance from the patterning device MA that is sufficient such that any particles that are incident upon the surface of the pellicle 19 are not in the focal plane of the radiation beam B. This separation between the pellicle 19 and the patterning device MA, acts to reduce the extent to which any particles on the surface of the pellicle 19 impart a pattern to the radiation beam B. It will be appreciated that where a particle is present in the beam of radiation B, but at a position that is not in a focal plane of the beam of radiation B (i.e., not at the surface of the patterning device MA), then any image of the particle will not be in focus at the surface of the substrate W. In some examples, the separation between the pellicle 19 and the patterning device MA may, for example, be between 2 mm and 3 mm (e.g. around 2.5 mm). In some examples, a separation between the pellicle 19 and the patterning device MA may be adjustable.

Figure 2 shows a schematic side view of an example pellicle assembly 15 and patterning device MA. The patterning device MA has a pattern 21 (e.g., a device or circuit pattern) that provides the pattern that is imparted to the radiation beam B after reflection from the patterning device MA. The pellicle 19 is in the radiation beam exposure position in the lithographic apparatus LA, i.e. the pellicle 19 is in-situ. The pellicle 19 may be relatively thin as a thinner pellicle 19 is better for transmission of the radiation beam, in particular for EUV, for example the pellicle 19 may have a thickness of less than 100 nm, or preferably less than 50 nm, or more preferably less than 20 nm.

The pellicle assembly 15 and the patterning device MA may first move in the direction left to right as depicted by arrow 20 (the y direction), i.e. the patterning device MA is scanned in this direction. The scanning may then occur in the opposite direction as generally, in a scanning lithographic apparatus, a patterning device MA is scanned in one direction and then in the opposite direction.

The radiation beam B (i.e. actinic energy), depicted by arrow 22, coming from the actinic energy source (not shown) towards the patterning device MA, and the radiation beam B, depicted by arrow 23, being reflected from the patterning device MA to the substrate W (see Figure 1), delivers a relatively large amount of energy to the pellicle 19. The pellicle is limited in the amount of heat that can be conducted away and hot spots can occur due to the large amount of energy delivered to the pellicle 19.

There are issues with such pellicles in handling heat and in some cases, this can lead to the pellicle breaking. If the pellicle breaks, the patterning device MA and/or the lithographic apparatus can become contaminated and the pattern imparted to the radiation beam B can be detrimentally affected. The patterning device MA may have to be replaced.

Various options are available for measuring breakages of the pellicle, for example, by using a sensor to look at the reflected light during alignment of the patterning device, for example, using markers present on the patterning device. Examples of known systems for carrying out such detection are disclosed in WO 2017/102380 A1 and WO 2019/115218 A1 which are hereby incorporated in their entirety by reference. With certain types of pellicle (for example, particularly those comprising silicon), when there is a breakage, the whole pellicle may break apart and this may be detected with known systems. However, improvements of known systems may be available.

As advancements are made, even higher temperature loads may be delivered to the pellicle. Thus, it may be beneficial to use materials for the pellicle are more capable of handling the heat load without breaking (e.g. CNT). However, when pellicles are formed of certain materials (such as CNT) they may break in a different way which may be harder to detect. For example, if the film only partially breaks a local rupture may be formed, but the pellicle may remain intact in other areas (e.g. due to high tensile strength). In this case the film rupture may not be detected by known sensors if the film is not broken at a location above the marker areas normally used for sensing. Thus, known systems may indicate that the pellicle is intact, when in fact, there is some form of rupture/hole elsewhere on the pellicle.

Other issues with known measurement systems include relatively long duration which can lead to throughput loss and/or a delay in determining that a pellicle has broken which increases the likelihood of contamination on the patterning device MA.

The present invention provides a system and method for detecting when there is a break in the pellicle. The present invention aims to reduce or mitigate at least some of the problems identified in the prior art. Furthermore, as will be understood from the below, the present invention is beneficial in that it may be compatible with pre-existing systems for holding a pellicle which may already be in place, and so can be provided on pre-existing systems without having to replace a pellicle, patterning device and/or corresponding supports to incorporate a further sensor.

The present invention provides a method of detecting a break in a pellicle, wherein the pellicle is suitable for use with a patterning device in a lithographic apparatus. Thus, the pellicle may be the same as the pellicle 19 described above. The present invention may be particularly beneficial when used with a pellicle 19 formed of materials which rupture without fully breaking, such as CNT, although the pellicle 19 may be formed of any appropriate material. The pellicle 19 can be used to protect the patterning device MA as described above. The patterning device MA can be held by the support structure MT.

The inventors have identified that when the pellicle ruptures, even when there is only a small tear or break, there is photon flux on the patterning device MA. When there is a break on the pellicle 19 during scanning this will result in locally higher change in photo-electric effect as locally more photons will hit the patterning device MA. This results in higher voltage change induced on the patterning device MA during exposure. The present invention uses the potential induced on the patterning device due to photons reaching the patterning device MA and the difference between such changed values to detect a break in the pellicle 19, as described further below.

The support structure MT can be electrically coupled to the patterning device MA. In other words, the support structure MT and the patterning device MA may be electrically connected, although this may not be a direct electrical connection. For example, the patterning device MA may be electrically connected to the support structure MT by capacitive coupling between the patterning device MA and electrodes of the support structure MT. Thus, a signal can be generated (and measured) via capacitive coupling between the patterning device MA and electrodes of the support structure MT. This is beneficial in that a pre-existing connection/coupling between the patterning device MA and the support structure MT can be used for carrying out the measurement, i.e. without having to make an additional connection/coupling. More specifically, the support structure MT may be configured to hold the patterning device MA using capacitive coupling via which the measurements are taken. Thus, it is not necessary to make an additional electrical connection to the pellicle 19 and/or patterning device MA.

The method comprises measuring a property associated with the potential induced on the patterning device due to photons reaching the patterning device MA during exposure. Thus, the method comprises measuring the property associated with the induced potential during exposure of the patterning device MA. The measurement can be carried out via the electrical coupling between the patterning device MA and the support structure MT. Furthermore, the method comprises detecting the break in the pellicle based on the measured property.

It is the variation of photons which reach the patterning device, e.g. due to a rupture in the pellicle 19, which induce the potential associated with the property. Thus, the potential induced on the patterning device MA relates to a surface of the patterning device MA exposed to radiation during exposure. In other words, the potential V_{FS} induced on the patterning device MA relates to a potential on the "front side" of the patterning device MA, i.e. a side of the patterning device MA facing towards the radiation beam.

The oscillating potential V_{FS} of the patterning device induces a high-frequency perturbation which can be measured. The potential of the patterning device MA changes in a short timescale (e.g. ns - µs) which causes high-frequency voltage fluctuations in the electrodes of the support structure MT which can be measured via the cables connected to the support structure MT.

A system of the present invention comprises the support structure for holding the patterning device and a sensor configured to measure the property via the electrical coupling. The support structure is electrically coupled to the patterning device MA as described above. The system is configured to detect a break in the pellicle based on the measured property.

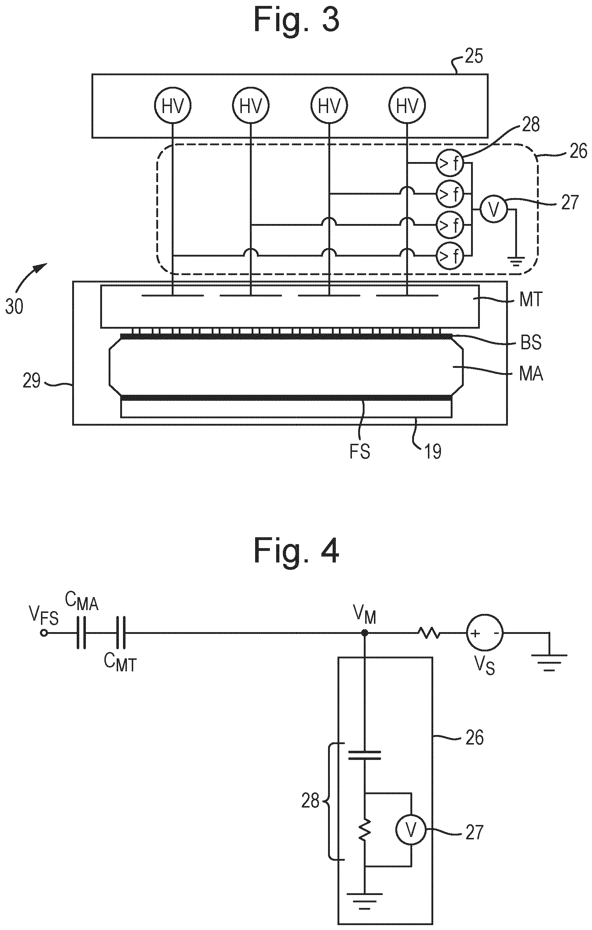

In an embodiment, the measured property is a voltage. Thus, the system may be configured to measure voltage. An embodiment in which the system 30 is configured to measure the voltage is shown in Figures 3 and 4. In this embodiment, the sensor 26 comprises a voltmeter 27 to measure the voltage V_{M}. The measured voltage V_{M} is proportional to the voltage VFS induced on the front surface FS of the patterning device MA. Thus, the measured signal V_{M} indicates the induced potential on the front side FS of the patterning device MA due to the radiation incident on the front side FS of the patterning device MA.

This may have the advantage of providing immediate feedback of a pellicle rupture for early detection of a rupture, e.g. when a hole first forms in the pellicle before full rupture or breakage. This may be particularly beneficial in minimising contamination of the patterning device MA, and may increase the likelihood of the patterning device MA being salvageable.

As shown in Figure 4, the sensor 26 can be attached via cables from the voltage source V_{S} which powers electrodes of the support structure MT. Figure 4 is representative of the electrical circuit/couplings (although not all of the components are shown, for example, the cables connecting the clamp electrodes to the voltage source V_{S} may be coaxial and may be represented between the support structure MT and the measured voltage V_{M}). For simplicity, these are not shown in Figure 4.

This may have an advantage of avoiding the need for multiple detectors throughout the system monitoring the pellicle or patterning device, thus reducing costs. Furthermore, the sensor beneficially provides in situ detection of the condition of the pellicle (without having to be physically connected directly to the pellicle).

The sensor 26 may include a high-pass filter 28, as shown in Figures 3 and 4, which filters signals below a selected cut-off point. For example, the high pass filter 28 may be configured to filter the voltage relating to the voltage source (V_{S}), and allow varying potential associated with the patterning device (i.e. corresponding to the induced potential on the patterning device V_{FS}) to be detected by the voltmeter 27. For example only, the time constant of the high pass filter 28 (provided by the resistor-capacitor circuit shown in Figure 4) could be approximately 20 ns to 500 ns. For example only, having a higher time constant, e.g. nearer the upper end of the range such as around 400 ns is beneficial in allowing for detection of a greater range of transient voltage peak on the patterning device front surface). For example only, the resistor in the resistor-capacitor circuit shown in Figure 4 may have a resistance of 50 Ω.

The sensor 27 can be provided outside of a main zone of the patterning device MA, support structure MT, and/or pellicle 19/pellicle assembly 17. Thus, the sensor can be positioned external to a housing 29 in which the support structure MT, patterning device MA and pellicle 19 are provided. For example, the sensor 27 can be attached to cables between the support structure 27 and the power source 25 (which provides V_{S}). The sensor 27 may be a "break-out box" with dedicated electronics on the outside of the housing 29. The present invention is particularly beneficial in that it allows for measurement of the pellicle 19 during use, without having to be positioned inside the housing 29 and without have to directly contact the patterning device MA and/or the pellicle 19.

The system 30 (or another part of the lithographic apparatus LA) may be configured to provide a vacuum in the housing 29 of the system 30 in which the support structure is provided, wherein the sensor 26 is positioned external to the housing.

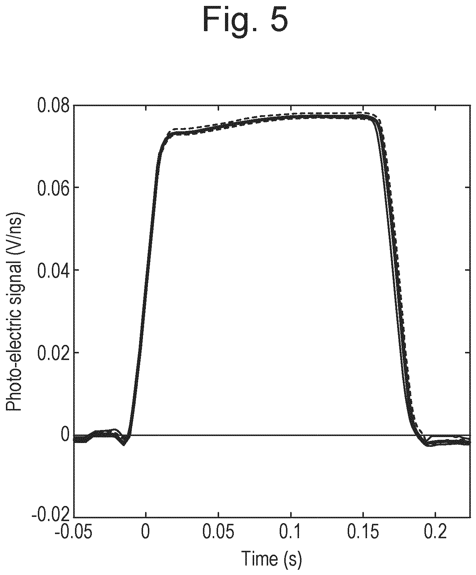

A graph showing an example of the voltage measured V_{M} during exposure of the patterning device MA is depicted in Figure 5. In particular, Figure 5 shows change in V_{M} (in V/ns) as detected by sensor 26 due to the photo-electric effect on the patterning device MA during exposure of a field during main pulses of the radiation beam B. The signal shown in Figure 5 corresponds to the exposure of a whole field over time. The value of the signal varies over time which corresponds to multiple exposures throughout the field. When the field is exposed again, the signal is generally expected to stay the same. Thus, a graph showing the signals for multiple exposures of the field should have substantially the same shape.

However, as described above, when there is a rupture or break in the pellicle 19, photons reaching the patterning device MA will induce voltage on the patterning device front side. Thus, V_{FS} will vary due to the photo-electric effect. This will result in a change in the measured voltage V_{M}. A conversion factor (for example, it may be that V_{M} = 0.0.8V_{FS}) can be applied to the measured voltage to determine the change in voltage at the patterning device front side V_{FS}. The change in voltage at the patterning device front side V_{FS} can thus be determined, i.e. having units V/ns.

The method may be configured to detect if a breakage has occurred by comparing values of the measured voltage V_{M}, and particularly by comparing the change of the measured voltage V_{M} over time. This may be done in various ways, for example, by comparing subsequent sets of exposures with each other to see if a difference of a given exposure (or number of exposures) within the field between one set of exposures and another set of exposures exceeds a threshold. Beneficially, using the measured voltage V_{M} allows for real time monitoring of the pellicle to detect if any breakages have occurred. This may be advantageous in preventing contamination of the patterning device MA, which might otherwise result in the patterning device MA needing to be replaced which would incur cost and lower overall throughput as the patterning device MA is replaced.

For example, comparing subsequent sets of exposures may comprise measuring the voltage during at least two sets of exposure. The method may be configured to compare measurements of the voltage during a first set of exposures with measurements of the voltage during at least one second set of exposures. In particular, the method may compare changes in voltage between different sets of exposures. The method may compare measurements during the full exposure, or during only a specific part of the exposure (e.g. within a specific time frame in graph 5 for each exposure). The first set of exposure may be an initial set of exposures. The first set of exposures may be considered to form a baseline against which further measurements can be compared. It may be that the baseline is updated (either continuously or at a given frequency of measurements), so as to provide as average or updated baseline against which at least one further set of exposures can be compared. The first set of exposures and the second set of exposures may be successive, i.e. the measurements may be taken during consecutive sets of exposures.

The method may further comprise determining changes in the measured voltage V_{M} over time. The method may further comprise identifying if a difference between the change in the measured property between the at least one further set of exposures and the first set of exposures exceeds a threshold value. The threshold value may be selected based on expected variation over time. However, it is likely that the threshold value is a difference in the change in the measured voltage within the set of exposures of greater than 2%, i.e. if a change in the measured voltage for a given pulse in the different sets of exposures differs by greater than 2%. Additionally or alternatively, the threshold value may be exceed if there is a difference in the change in the voltage measured in at least 10% of the measured values within the set of exposures of at least 1%, i.e. if a change of a measured voltage for a given number of pulses (e.g. for 10% of the pulses within one set of exposures) differs from a change of a measured voltage for the given number of pulses in a further set of exposures by greater than 1%. These values may be set as preferred depending on expected variation between exposures.

For example only, a first set of exposures measured to have a baseline of about 0.8 V/ns with variation of approximately 1.9 % (i.e. less than 2%) between each exposure per patterning device or a standard deviation of approximately 0.5%. Therefore, independent of the baseline value, if there is a change due to pellicle rupture which is greater than 2% of the baseline (one exposure) the present method is able to detect it.

The break in the pellicle may be detected when at least one of the threshold values is exceeded. Multiple threshold values could be exceeded simultaneously.

Although the comparison, determination and detection could theoretically be carried out manually, e.g. by a human operator, it would likely be more efficient to involve some form of computing apparatus. The system 30 may be configured to carry out the comparison, determination and/or detection steps described above. For example, the system may comprise a processor configured to carry out at least one of these steps.

Further to the above, when a break in the pellicle is detected, the method may comprise displaying an error signal and/or preventing further exposure of the patterning device. The error signal may be displayed on any appropriate display on the system (e.g. on the sensor itself) and/or on another part of the lithographic apparatus LA. For example, the sensor 27 may be configured to send a signal to the controller 50 to indicate that the pellicle 19 is broken so as to display an error signal via another means. The error signal may include operating a lightbulb indicating an error or sounding an alert or showing a message on a display screen. The sensor 26 may be configured to send a signal to the controller 50 to indicate that the pellicle 19 is broken so as to stop the exposure of the patterning device MA and preferably prevent further exposure of the patterning device MA. This may be particularly beneficial in minimising contamination of the patterning device MA, and may increase the likelihood of the patterning device MA being salvageable.

In the embodiments and variations described above, the measurements are carried out based on measured voltage which is indicative of the potential induced on the patterning device. In an alternative embodiment, the measured property is current. The current can be measured at the same location as the probe used for measuring voltage as shown in Figure 4. For example, the AC current can be measured by implementing a pick-up coil sensor around the cable between the patterning device MA and the voltage source 25. The signal in the cable, which varies due to potential induced on the patterning device, creates a change in the magnetic field around cable. The change of magnetic field can be detected by a pick-up coil and converted into an electrical signal. A sensor for measuring the current of the electrical signal from the pick-up coil can be used to measure changes in the current through the cable, which is indicative of changes of the potential induced on the patterning device.

The steps of comparing, determining and/or detecting may be based on the same steps as described above in relation to measurements based on the voltage. For example, the same percentage values may be used for the threshold, such that breakage of the pellicle is detected when the given threshold of a change in measured current is exceeded.

As will be understood, the system can be part of a lithographic apparatus, such as lithographic apparatus LA described above. The lithographic apparatus may comprise at least the illumination system configured to condition a radiation beam, the system as described in any of the embodiments or variations described herein. The patterning device is capable of imparting the radiation beam with a pattern to form the patterned radiation beam. The lithographic may further comprise at least the substrate table configured to hold a substrate and the projection system configured to project the patterned radiation beam onto the substrate.

As described, the present invention may be particularly beneficial in that the sensor can be positioned outside of the main body of the patterning device MA and support structure MA, due to the way in which the measurements are carried out. This is beneficial in that the sensor 26 may be retrofitted to a lithographic apparatus without having to change other aspects or components of the lithographic apparatus. For example, in the present invention, the system as described in any of the above embodiments or variations may be provided and a method may comprise attaching the sensor 26 to the support structure MT, wherein the support structure MT comprises a pre-existing electrical coupling between the support structure MT and the patterning device MA. The sensor 26 can be attached to a cable between the support structure MA and the power source 25.

A computer program may be used which comprises computer readable instructions configured to cause a computer to carry out a at least some steps of the method described herein (such as the comparison, determination and/or detection steps). A computer readable medium may carry this computer program.

A computer apparatus (e.g. controller 50) may be used to determine the condition of the pellicle 19. The computer apparatus may include a memory storing processor readable instructions and a processor arranged to read and execute instructions stored in the memory. The processor readable instructions may comprise instructions arranged to control the computer to carry out a method described herein.

In an example, an embodiment of the invention may form part of a patterning device (mask) MA inspection apparatus. The patterning device inspection apparatus may use EUV radiation to illuminate a patterning device (e.g., a mask) and use the sensor 27 to monitor the pellicle. The patterning device inspection apparatus may include a processor configured to analyse data from the sensor 27, and to determine from that analysis whether any defects are present on the pellicle.

Although specific reference may be made in this text to examples of the invention in the context of a lithographic apparatus, examples of the invention may be used in other apparatus. Examples of the invention may form part of a patterning device inspection apparatus, a metrology apparatus, or any apparatus that measures or processes an object such as a wafer (or other substrate) or a mask (or other patterning device). These apparatus may be generally referred to as lithographic tools. Such a lithographic tool may use vacuum conditions or ambient (non-vacuum) conditions.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although Figure 1 depicts the radiation source SO as a laser produced plasma LPP source, any suitable source may be used to generate EUV radiation. For example, EUV emitting plasma may be produced by using an electrical discharge to convert fuel (e.g. tin) to a plasma state. A radiation source of this type may be referred to as a discharge produced plasma (DPP) source. The electrical discharge may be generated by a power supply which may form part of the radiation source or may be a separate entity that is connected via an electrical connection to the radiation source SO.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may have been made above to the use of examples of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Examples of the invention may be implemented in hardware, firmware, software, or any combination thereof. Examples of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

While specific examples of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims and clauses set out below.

Exemplary embodiments of the invention are set out in the following numbered clauses:
1. An system for detecting a break in a pellicle for use with a patterning device in a lithographic apparatus, the system comprising:
   a support structure for holding a patterning device, the support structure being electrically coupled to the patterning device;
   a sensor configured to measure, via the electrical coupling, a property associated with potential induced on the patterning device due to photons reaching the patterning device during exposure,
   wherein the system is configured to detect the break in the pellicle based on the measured property.
2. The system of clause 1, wherein the sensor is configured to measure the property during exposure of the patterning device.
3. The system of any one of the preceding clauses, wherein the measured property is voltage.
4. The system of either one of clauses 1 or 2, wherein the measured property is current.
5. The system of any one of the preceding clauses, wherein the support structure is configured to hold the patterning device using capacitive coupling via which measurements are taken.
6. The system of any one of the preceding clauses, wherein potential induced on the patterning device relates to a surface of the patterning device exposed to radiation during exposure.
7. The system of any one of the preceding clauses, wherein the system is configured to compare measurements of the property during a first set of exposures with measurements of the property during at least one second set of exposures.
8. The system of clause 7, wherein the system is configured to determine changes in the measured property over time and identify if a difference between the change in the measured property over time between the at least one second set of exposures and the first set of exposures exceeds a threshold value.
9. The system of clause 8, wherein the threshold value is a difference in the change in a measured value within the set of exposures of greater than 2%.
10. The system of clause 8, wherein the threshold value is a difference in the change in the measured values of at least 1%, wherein the difference is in at least 10% of the measured values within the set of exposures.
11. The system of any one clauses 8 to 10, wherein the system detects a break of the pellicle when the threshold value is exceeded.
12. The system of any one of the preceding clauses, wherein the system comprises a housing in which the support structure is provided and the sensor is positioned external to the housing.
13. The system of clause 12, wherein the system is configured to provide a vacuum within the housing.
14. A lithographic apparatus comprising:
   an illumination system configured to condition a radiation beam;
   the system of any one of the preceding clauses, wherein the patterning device is capable of imparting the radiation beam with a pattern to form a patterned radiation beam;
   a substrate table configured to hold a substrate; and
   a projection system configured to project the patterned radiation beam onto the substrate.
15. The lithographic apparatus of clause 14, wherein the lithographic apparatus is configured to display an error signal, stop and/or prevent further exposure of the patterning device when a break in the pellicle is detected by the system.
16. A method of detecting a break in a pellicle for use with a patterning device in a lithographic apparatus, wherein the patterning device is held by a support structure which is electrically coupled to the patterning device, the method comprising measuring, via the electrical coupling, a property associated with potential induced on the patterning device due to photons reaching the patterning device during exposure and detecting the break in the pellicle based on the measured property.
17. The method of clause 16, wherein the measuring is carried out during exposure of the patterning device.
18. The method of either one of clauses 16 or 17, wherein the measured property is a voltage.
19. The method of either one of clauses 16 or 17, wherein the measured property is current.
20. The method of any one of clauses 16 to 19, wherein the support structure is configured to hold the patterning device using capacitive coupling via which measurements are taken.
21. The method of any one of clauses 16 to 20, wherein potential induced on the patterning device relates to a surface of the patterning device exposed to radiation during exposure.
22. The method of any one of clauses 16 to 21, further comprising comparing measurements of the property during a first set of exposures with measurements of the property during at least one second set of exposures.
23. The method of clause 22, further comprising determining changes in the measured property over time and identifying if a difference between the change in the measured property between the at least one second set of exposures and the first set of exposures exceeds a threshold value.
24. The method of clause 23, wherein the threshold value is a difference in the change in a measured value within the set of exposures of greater than 2%.
25. The method of clause 22 or 23, wherein the threshold value is a difference in the change in the measured values of at least 1%, wherein the difference is in at least 10% of the measured values within the set of exposures.
26. The method of any one of clauses 23 to 25, wherein the break in the pellicle is detected when the threshold value is exceeded.
27. The method of any one of clauses 16 to 26, further comprising providing a vacuum in a housing of the system in which the support structure is provided, wherein the sensor is positioned external to the housing.
28. The method of any one of clauses 16 to 27, further comprising displaying an error signal when a break in the pellicle is detected by the system.
29. The method of any one of clauses 16 to 28, further comprising stopping exposure and/or preventing further exposure of the patterning device when a break in the pellicle is detected by the system.
30. A method of providing the system as in any one of clauses 1 to 15, wherein the method comprises attaching the sensor to the support structure, wherein the support structure comprises a pre-existing electrical coupling between the support structure and the patterning device.

## Claims

1. A system for detecting a break in a pellicle for use with a patterning device in a lithographic apparatus, the system comprising:
a support structure for holding a patterning device, the support structure being electrically coupled to the patterning device;
a sensor configured to measure, via the electrical coupling, a property associated with potential induced on the patterning device due to photons reaching the patterning device during exposure,
wherein the system is configured to detect the break in the pellicle based on the measured property.

2. The system of claim 1, wherein the sensor is configured to measure the property during exposure of the patterning device.

3. The system of any one of the preceding claims, wherein the measured property is voltage.

4. The system of either one of claims 1 or 2, wherein the measured property is current.

5. The system of any one of the preceding claims, wherein the support structure is configured to hold the patterning device using capacitive coupling via which measurements are taken.

6. The system of any one of the preceding claims, wherein potential induced on the patterning device relates to a surface of the patterning device exposed to radiation during exposure.

7. The system of any one of the preceding claims, wherein the system is configured to compare measurements of the property during a first set of exposures with measurements of the property during at least one second set of exposures.

8. The system of claim 7, wherein the system is configured to determine changes in the measured property over time and identify if a difference between the change in the measured property over time between the at least one second set of exposures and the first set of exposures exceeds a threshold value.

9. The system of claim 8, wherein the threshold value is a difference in the change in a measured value within the set of exposures of greater than 2%.

10. The system of claim 8, wherein the threshold value is a difference in the change in the measured values of at least 1%, wherein the difference is in at least 10% of the measured values within the set of exposures.

11. The system of any one claims 8 to 10, wherein the system detects a break of the pellicle when the threshold value is exceeded.

12. The system of any one of the preceding claims, wherein the system comprises a housing in which the support structure is provided and the sensor is positioned external to the housing.

13. The system of claim 12, wherein the system is configured to provide a vacuum within the housing.

14. A lithographic apparatus comprising:
an illumination system configured to condition a radiation beam;
the system of any one of the preceding claims, wherein the patterning device is capable of imparting the radiation beam with a pattern to form a patterned radiation beam;
a substrate table configured to hold a substrate; and
a projection system configured to project the patterned radiation beam onto the substrate.

15. The lithographic apparatus of claim 14, wherein the lithographic apparatus is configured to display an error signal, stop and/or prevent further exposure of the patterning device when a break in the pellicle is detected by the system.

16. A method of detecting a break in a pellicle for use with a patterning device in a lithographic apparatus, wherein the patterning device is held by a support structure which is electrically coupled to the patterning device, the method comprising measuring, via the electrical coupling, a property associated with potential induced on the patterning device due to photons reaching the patterning device during exposure and detecting the break in the pellicle based on the measured property.

17. The method of claim 16, wherein the measuring is carried out during exposure of the patterning device.

18. The method of either one of claims 16 or 17, wherein the measured property is a voltage.

19. The method of either one of claims 16 or 17, wherein the measured property is current.

20. The method of any one of claims 16 to 19, wherein the support structure is configured to hold the patterning device using capacitive coupling via which measurements are taken.

21. The method of any one of claims 16 to 20, wherein potential induced on the patterning device relates to a surface of the patterning device exposed to radiation during exposure.

22. The method of any one of claims 16 to 21, further comprising comparing measurements of the property during a first set of exposures with measurements of the property during at least one second set of exposures.

23. The method of claim 22, further comprising determining changes in the measured property over time and identifying if a difference between the change in the measured property between the at least one second set of exposures and the first set of exposures exceeds a threshold value.

24. The method of claim 23, wherein the threshold value is a difference in the change in a measured value within the set of exposures of greater than 2%.

25. The method of claim 22 or 23, wherein the threshold value is a difference in the change in the measured values of at least 1%, wherein the difference is in at least 10% of the measured values within the set of exposures.

26. The method of any one of claims 23 to 25, wherein the break in the pellicle is detected when the threshold value is exceeded.

27. The method of any one of claims 16 to 26, further comprising providing a vacuum in a housing of the system in which the support structure is provided, wherein the sensor is positioned external to the housing.

28. The method of any one of claims 16 to 27, further comprising displaying an error signal when a break in the pellicle is detected by the system.

29. The method of any one of claims 16 to 28, further comprising stopping exposure and/or preventing further exposure of the patterning device when a break in the pellicle is detected by the system.

30. A method of providing the system as in any one of claims 1 to 15, wherein the method comprises attaching the sensor to the support structure, wherein the support structure comprises a pre-existing electrical coupling between the support structure and the patterning device.
